# EUROPEAN PATENT SPECIFICATION

(11) **EP 3 323 608 B1**
(45) Date of publication and mention of the grant of the patent: **14.02.2024**
(21) Application number: 16824477.0
(22) Date of filing: 13.07.2016
(51) Int. Cl.: B32B 7/12, B32B 17/10, C03B 17/00, C03B 35/00, H05B 33/04

(54) **PRODUCTION METHOD FOR OPTICAL LAMINATE**
HERSTELLUNGSVERFAHREN FÜR OPTISCHES LAMINAT
PROCÉDÉ DE PRODUCTION POUR STRATIFIÉ OPTIQUE

(30) Priority: 15.07.2015 JP 2015141265
(43) Date of publication of application: 23.05.2018
(73) Proprietor: Nitto Denko Corporation, Ibaraki-shi, Osaka 567-8680 (JP)
(72) Inventor: INAGAKI, Junichi, Ibaraki-shi Osaka 567-8680 (JP); MURASHIGE, Takeshi, Ibaraki-shi Osaka 567-8680 (JP); HOSOKAWA, Kazuhito, Ibaraki-shi Osaka 567-8680 (JP)
(74) Representative: Hoffmann Eitle
(86) International application number: PCT/JP2016/070638
(87) International publication number: WO 2017/010497

(56) References cited:
- WO-A1-2012/108866
- WO-A1-2013/114979
- WO-A2-2014/172237
- JP-A- 2001 097 733
- JP-A- 2013 014 441
- JP-A- 2014 215 592
- JP-A- 2015 007 764
- US-A1- 2010 192 634
- US-A1- 2015 017 347
- US-B1- 6 815 070

## Description

### Technical Field

The present invention relates to a method of producing an optical laminate.

### Background Art

An optical laminate formed of a glass material and an optical film has hitherto been used as a constituent member of an image display apparatus, such as a substrate for a display element, a sealing material of an OLED element, or an overall protective sheet. In general, such optical laminate is produced as follows: a glass material is produced, and then an optical film is bonded onto the glass material with an adhesive or an application liquid serving as a material for the optical film is applied onto the glass material. When the glass material is thin enough to be flexible, the glass material is produced into a roll shape, and the bonding or application is performed on glass fed from a roll.

WO 2014/172237 A2 describes a method of forming a laminated glass structure that includes introducing a continuous ribbon of flexible glass substrate having a thickness of no greater than 0.3 mm to a substrate material. The substrate material has a coefficient of thermal expansion that is greater than that of the flexible glass substrate. The flexible glass substrate is laminated to the substrate material at an elevated temperature . The substrate material is cooled to introduce a compressive stress across a thickness of the flexible glass substrate.

US 2010/192634 A1 describes a process for producing a glass/resin composite which comprises forming molten glass into a glass ribbon and forming a resin layer on at least one surface of the glass ribbon. The resin layer is preferably formed by bonding to a glass ribbon, applying a heat melt resin or applying a curable resin.

Meanwhile, in recent years, weight saving and thinning of the image display apparatus have been progressing, and the use of a thinner glass material has been required. The glass material originally has poor handleability owing to its fragility. In this connection, when the glass material to be used as a material becomes thinner, its handleability poses a more remarkable problem, resulting in a reduction in production efficiency.

### Citation List

### Patent Literature

[PTL 1] JP 4122139 B2
[PTL 2] WO 2014/172237 A2
[PTL 3] US 2010/192634 A1

### Summary of Invention

### Technical Problem

The present invention has been made in order to solve the problem of the related art, and an obj ect of the present invention is to provide a production method for an optical laminate, which is excellent in production efficiency even through use of a thin glass.

### Solution to Problem

According to one embodiment of the present invention, there is provided a production method for an optical laminate, the production method including: a thin glass production step of producing a thin glass having a thickness of 100 um or less; and a lamination step of laminating an optical film on one surface, or each of both surfaces, of the thin glass, the thin glass production step and the lamination step being performed in an integrated line, wherein thin glass continuously formed in the thin glass production step is subjected to the lamination step as it is without being taken up, the lamination step including applying an adhesive onto the optical film to form an application layer, and bonding the thin glass and the optical film through intermediation of the application layer while thin glass is inserted into a pair of rolls from below, followed by curing the adhesive to form an adhesive layer between the optical film and the thin glass.

In one embodiment, the optical film has a modulus of elasticity at 23°C of from 1.5 GPa to 10 GPa.

In one embodiment, the adhesive layer has a thickness of from 0.001 um to 20 um.

In one embodiment, the application layer formed through the application of the adhesive has a curing shrinkage rate of from 0.1% to 30%.

### Advantageous Effects of Invention

According to the present invention, the thin glass production step and the step of laminating an optical film on the thin glass are performed in the integrated line, and hence the production method for an optical laminate, which is excellent in production efficiency even through use of a thin glass, can be provided.

### Brief Description of Drawings

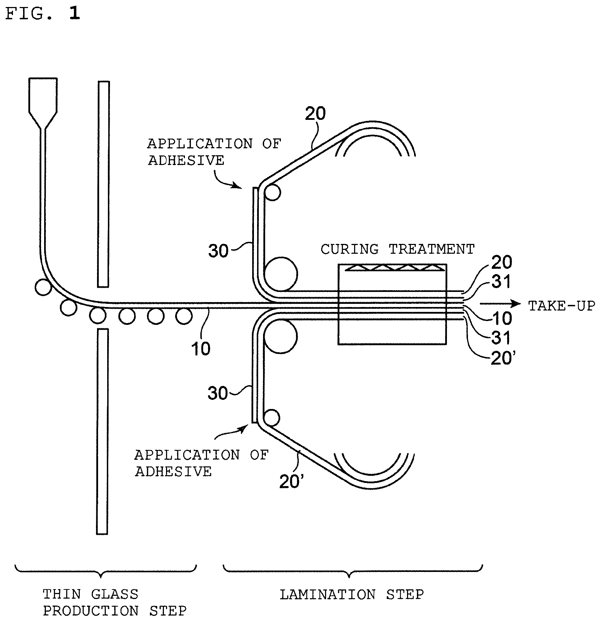

FIG. 1 is a view for illustrating a production method for an optical laminate according to one embodiment of the present invention.

### Description of Embodiments

FIG. **1** is a view for illustrating a production method for an optical laminate according to one embodiment of the present invention. It should be noted that FIG. **1** is schematically illustrated so that a configuration is clearly shown and is not illustrated to scale. The production method for an optical laminate of this embodiment includes: (a) a step of producing a thin glass **10** (hereinafter sometimes referred to as thin glass production step) ; and (b) a step of laminating optical films **20** and **20'** on the thin glass **10** (hereinafter sometimes referred to as lamination step). In the production method for an optical laminate of the present invention, the thin glass production step and the lamination step are performed in an integrated line. More specifically, the thin glass continuously formed in the thin glass production step is subjected to the lamination step as it is without being taken up.

### A. Thin Glass Production Step

Any appropriate method may be adopted as a production method for the thin glass **10.** The thin glass **10** is typically produced as follows: a mixture containing a main raw material, such as silica or alumina, an antifoaming agent, such as mirabilite or antimony oxide, and a reducing agent, such as carbon, is melted at a temperature of from 1,400°C to 1,600°C, and formed into a thin sheet shape, followed by cooling. As a method of forming the thin glass **10** into a thin sheet, there are given, for example, a slot down-draw method, a fusion method, and a float method. The thin glass formed into a sheet shape by those methods may be chemically polished with a solvent such as hydrofluoric acid, as required, for further thinning the thin glass or increasing its smoothness.

A line speed in the thin glass production step is preferably 1 m/min or more, more preferably 5 m/min or more, still more preferably 10 m/min or more, particularly preferably 15 m/min or more, most preferably 20 m/min or more. The upper limit of the line speed is preferably 100 m/min or less, more preferably 60 m/min or less. In the present invention, the thin glass production step and the lamination step are performed in an integrated line, and hence the line speed in the thin glass production step and a line speed in the lamination step are the same, and these speeds also correspond to a line speed of the integrated line.

The thin glass **10** has a thickness of 100 um or less, preferably 80 um or less, more preferably 50 um or less, still more preferably 40 um or less, particularly preferably from 10 um to 35 um. In the present invention, even when the thin glass having an extremely small thickness is used, the glass is prevented from being broken, and hence an optical laminate can be obtained with high production efficiency.

The thin glass **10** has a width of preferably from 500 mm to 2,000 mm, more preferably from 750 mm to 1,500 mm.

The thin glass **10** preferably has a light transmittance at a wavelength of 550 nm of 85% or more. The thin glass **10** preferably has a refractive index n_{g} at a wavelength of 550 nm of from 1.4 to 1.65.

The density of the thin glass **10** is preferably from 2.3 g/cm³ to 3. 0 g/cm³, more preferably from 2.3 g/cm³ to 2.7 g/cm³. When the thin glass **10** has a density falling within the above-mentioned range, a lightweight optical laminate is obtained.

The thin glass **10** preferably has an elongated shape. The thin glass **10** has a length of, for example, from 10 m to 5,000 m, preferably from 50 m to 5,000 m.

The thin glass **10** formed into a predetermined thickness and a predetermined width in the thin glass production step is conveyed to the subsequent lamination step by any appropriate conveying method without being taken up in the thin glass production step. Examples of the conveying method include roll conveyance and belt conveyance.

### B. Lamination Step

In the lamination step, an optical film is laminated on one surface, or each of both surfaces, of the thin glass. In one embodiment, as in the illustrated example, the optical films **20** and **20'** are laminated on both surfaces of the thin glass **10.** Alternatively, in another embodiment, an optical film is laminated on one of the surfaces of the thin glass, and a resin film is laminated on the other surface . The resin film mainly functions as a protective film configured to protect the thin glass. Alternatively, in still another embodiment, an optical film is laminated on one of the surfaces of the thin glass, and an optical laminate including the thin glass and the one optical film is produced.

Examples of each of the optical films **20** and **20'** include a polarizing plate, a retardation plate, and an isotropic film.

Any appropriate material is used as a material for forming each of the optical films **20** and **20'.** Examples of the material for forming each of the optical films **20** and **20'** include a polyvinyl alcohol (PVA) -based resin, a polyolefin-based resin, a cyclic olefin-based resin, a polycarbonate-based resin, a cellulose-based resin, a polyester-based resin, a polyvinyl alcohol-based resin, a polyamide-based resin, a polyimide-based resin, a polyether-based resin, a polystyrene-based resin, a (meth)acrylic resin, a (meth) acrylic urethane-based resin, a polysulfone-based resin, an acetate-based resin, an epoxy-based resin, and a silicone-based resin. In addition, a metal film, a metal oxide film, such as an ITO film, or a laminate film of the metal film and a resin film may also be used as each of the optical films **20** and **20'.**

Any appropriate material is used as a material for forming the resin film. A thermoplastic resin is preferably used as the material for forming the resin film. Examples of the resin include: a polyethersulfone-based resin; a polycarbonate-based resin; an acrylic resin; polyester-based resins, such as a polyethylene terephthalate-based resin and a polyethylene naphthalate-based resin; a polyolefin-based resin; cycloolefin-based resins, such as a norbornene-based resin; a polyimide-based resin; a polyamide-based resin; a polyimide amide-based resin; a polyarylate-based resin; a polysulfone-based resin; and a polyether imide-based resin. Alternatively, cross-linking resins, such as an epoxy-based resin, a urethane-based resin, and a silicone-based resin, may be used.

The optical films **20** and **20'** and the resin film each have a modulus of elasticity at 23°C of preferably from 1.5 GPa to 10 GPa, more preferably from 1.8 GPa to 9 GPa, still more preferably from 1.8 GPa to 8 GPa. When the optical films **20** and **20'** and the resin film each have a modulus of elasticity falling within the above-mentioned range, a high protective effect is exhibited on the thin glass, and the production method for an optical laminate excellent in production efficiency can be provided. In the present invention, the modulus of elasticity may be measured through dynamic viscoelastic spectrum measurement.

The thickness of each of the optical films **20** and **20'** may be set to any appropriate thickness depending on the application of each optical film. The thickness of each of the optical films **20** and **20'** is, for example, from 1 um to 300 um, preferably from 5 um to 200 um. The thickness of the resin film is preferably from 1 µm to 60 um, more preferably from 10 µm to 50 um, still more preferably from 20 µm to 40 µm.

The optical films **20** and **20'** and the resin film each have a width of preferably from 300 mm to 2,200 mm, more preferably from 500 mm to 2,000 mm, still more preferably from 750 mm to 1,500 mm. When the films are arranged on both surfaces of the thin glass **10,** these films may have the same width or different widths.

In one embodiment, the optical films **20** and **20'** and the resin film each have a width smaller than that of the thin glass. When the optical films **20** and **20'** and the resin film each have a width smaller than that of the thin glass, skewing and meandering of the thin glass can be corrected through edge detection of an edge portion of the thin glass in a width direction after the lamination step. As a result, the thin glass is prevented from being broken while being taken up. Alternatively, in another embodiment, the optical films **20** and **20'** and the resin film each have a width larger than that of the thin glass **10.** When the optical films **20** and **20'** and the resin film each have a width larger than that of the thin glass **10,** the end portion of the thin glass **10** is protected, and thus the thin glass **10** can be prevented from being broken in the course of the step.

The optical films **20** and **20'** and the resin film each preferably have an elongated shape. The lamination of those films may be continuously performed on the thin glass **10** having an elongated shape. In addition, the optical films **20** and **20**' and the resin film each have the same length as or a different length from that of the thin glass **10.** In addition, when the films are arranged on both surfaces of the thin glass **10,** these films may have the same length or different lengths.

In the present invention, the optical films **20** and **20'** are each laminated on the thin glass through intermediation of an adhesive layer **31.** More specifically, in the lamination step, an adhesive is applied onto the optical films **20** and **20'** to form application layers **30,** and then the thin glass **10** and the optical films **20** and **20'** are bonded to each other through intermediation of the application layers **30,** followed by curing the adhesive. By curing the adhesive (that is, the application layers **30'**), the adhesive layers **31** are formed. In the present invention, the thin glass production step and the lamination step are performed in an integrated line, and hence the thin glass production step and the lamination step have the same line speed. In addition, a line speed in glass production generally becomes faster as a glass to be produced has a smaller thickness. In the present invention, the thin glass to be produced in the thin glass production step has an extremely small thickness, and hence an overall line speed of the integrated line becomes fast, and also the line speed in the lamination step becomes fast. In the production method having such configuration, in which the thin glass and the optical film are bonded to each other after the formation of the application layer of the adhesive, and the adhesive layer is formed by curing the adhesive as described above, an inconvenience, such as a bonding failure, can be prevented, and in addition, a line length can be shortened.

Any appropriate adhesive is used as the adhesive. Examples of the adhesive include adhesives containing a resin having a cyclic ether group, such as an epoxy group, a glycidyl group, or an oxetanyl group, an acrylic resin, and a silicone-based resin. Of those, a UV-curable adhesive is preferably used. When the films are arranged on both surfaces of the thin glass **10,** the adhesives to be applied onto both surfaces of the thin glass **10** may be of the same kind or different kinds.

As a method of applying the adhesive, there are given: coating methods, e.g., air doctor coating, blade coating, knife coating, reverse coating, transfer roll coating, gravure roll coating, kiss coating, cast coating, spray coating, slot orifice coating, calender coating, electrocoating, dip coating, and die coating; and printing methods, e.g., relief printing methods, such as flexographic printing, intaglio printing methods, such as a direct gravure printing method and an offset gravure printing method, litho printing methods, such as an offset printing method, and stencil printing methods, such as a screen printing method.

The application layer **30** of the adhesive has a thickness of preferably from 0.001 um to 20 um, more preferably from 0.005 um to 20 um, still more preferably from 0.01 um to 10 um, particularly preferably from 0.1 um to 10 um. When the films are arranged on both surfaces of the thin glass **10,** the application layers to be formed on both surfaces of the thin glass **10** may have the same thickness or different thicknesses.

In one embodiment, the thin glass **10** and the optical films **20** and **20'** are bonded to each other after a predetermined interval after the formation of the application layers on the optical films **20** and **20'** through the application of the adhesive.

The adhesive may be semi-cured after the formation of the application layers **30** on the optical films **20** and **20'** through the application of the adhesive and before the bonding of the thin glass **10** and the optical films **20** and **20'.**

Subject to the appended claims, any appropriate method may be adopted as a method of bonding the thin glass **10** and the optical films **20** and **20'** to each other. When the optical films **20** and **20'** are laminated on both surfaces of the thin glass **10,** the two optical films **20** and **20'** may be laminated at the same timing or different timings.

In one embodiment, the thin glass **10** and the optical films **20** and **20'** each having formed thereon the application layer **30** of the adhesive are caused to run between a pair of rolls, and thus the thin glass **10** and the optical films **20** and **20'** are bonded to each other. In the present invention, the thin glass **10** and the optical films **20** and **20'** are laminated on each other after the application layers **30** of the adhesive are formed on the optical films **20** and **20'** in advance. Therefore, a pressure applied by the pair of rolls can be reduced, and hence the thin glass **10** is prevented from being broken. More specifically, a roll gap can be expanded or the surface hardness of each roll can be set to low hardness, and hence the thin glass is prevented from being broken. A gap between the pair of rolls is preferably from 50% to 99%, more preferably from 60% to 99%, still more preferably from 70% to 99%, particularly preferably from 80% to 99%, most preferably from 90% to 98% with respect to the total thickness of the thin glass, the application layer of the adhesive, and the optical film. When two optical films are laminated with a pair of rolls as in the illustrated example, the "total thickness of the thin glass, the application layer of the adhesive, and the optical film" means the total thickness of the thin glass, the application layers of the adhesive, and the two optical films. In addition, the roll to be used for the bonding has a rubber hardness of preferably from 10 degrees to 95 degrees, more preferably from 20 degrees to 90 degrees. In one embodiment, the roll to be used for the bonding has a rubber hardness of preferably 95 degrees or less, more preferably from 20 degrees to 90 degrees, still more preferably from 50 degrees to 90 degrees, particularly preferably from 50 degrees to 80 degrees. The rubber hardness is measured in conformity with JIS K-6253 (A type).

When the optical films are laminated on both surfaces of the thin glass, the two optical films may be laminated with a pair of rolls, or the two optical films may be separately laminated each with a pair of rolls.

In addition, in one embodiment, the thin glass is inserted into the pair of rolls from below at the time of bonding (that is, the thin glass is caused to run upward) . With this, the thin glass and the optical film can be bonded to each other while a situation in which the thin glass is accompanied by air is prevented, because the rolls are configured to rotate in a direction opposite to an own weight direction of air (downward direction) . As a result, a failure in adhesiveness between the thin glass and the optical film, and an outer appearance failure of the optical laminate can be prevented. In addition, in order to prevent air from being taken in between the thin glass and the optical film, for example, a method involving increasing a pressure applied by the rolls or increasing the hardness of each roll to an extent not to break the thin glass may be adopted.

Also for bonding of the resin film to the thin glass, a method similar to the above-mentioned method for the optical film may be adopted.

After each of the optical films **20** and **20'** is bonded to the thin glass **10,** the application layer **30** of the adhesive is cured. As amethodof curing the adhesive, there is given, for example, a method of curing the adhesive through ultraviolet light irradiation and/or heat treatment. Typical ultraviolet light irradiation conditions are as follows: a cumulative irradiation light amount of from 100 mJ/cm² to 2,000 mJ/cm², preferably from 200 mJ/cm² to 1,000 mJ/cm².

The adhesive is preferably cured through ultraviolet ray irradiation. The curing of the adhesive through ultraviolet ray irradiation easily responds to thinning of glass and increase of the line speed.

The curing shrinkage rate of the application layer of the adhesive is preferably from 0.1% to 30%, more preferably from 0.5% to 20%. The "curing shrinkage rate of the application layer of the adhesive" refers to a volume change rate when the application layer of the adhesive is cured to form the adhesive layer, and is calculated based on the expression: { (volume of application layer-volume of adhesive layer) /volume of application layer} . The curing shrinkage rate may be measured with a cure shrinkage sensor manufactured by Sentech "resin cure shrinkage stress measuring device EU201C". The details of a method of measuring the curing shrinkage rate are described in JP 2013-104869 A.

In one embodiment, when the optical films are laminated on both surfaces of the thin glass, the adhesive is cured after the optical films are bonded to both surfaces of the thin glass. In another embodiment, a first optical film is bonded to one of the surfaces of the thin glass, followed by curing an adhesive arranged between the thin glass and the first optical film, and then, a second optical film is bonded to the other surface of the thin glass, followed by curing an adhesive arranged between the thin glass and the second optical film.

Also when the resin film is laminated on the thin glass, the thin glass and the resin film may be laminated on each other by curing the adhesive as described above.

By curing the adhesive as described above, the adhesive layer **31** is formed between the thin glass **10** and each of the optical films **20** and **20'.** As a result, an optical laminate is obtained.

The adhesive layer **31** has a thickness of preferably from 0.001 um to 20 um, more preferably from 0.01 um to 10 um. The adhesive layer **31** having such thickness has less influence on transparency of a transparent substrate, and can exhibit sufficient adhesive force even under high temperature and high humidity conditions.

In the production method of the present invention, the thin glass may be slit at both ends in a width direction at any appropriate timing. The thin glass can be prevented frombeingbroken when both ends of the thin glass in a width direction, which have been damaged in the thin glass production step, are slit to be removed. In one embodiment, the slitting is performed before the bonding of the thin glass and the optical film (that is, under the state of the thin glass alone). In another embodiment, the slitting is performed after the lamination of the thin glass and the optical film and before a take-up step described below.

In one embodiment, the optical laminate produced as described above is subjected to a take-up step. An optical laminate taken up in a roll shape is obtained through the take-up step. Thus, the integrated process is completed. In addition, after the lamination step, that is, after the optical laminate has been formed, the optical laminate may be subjected to any appropriate treatment and then taken up.

### Industrial Applicability

The optical laminate obtained by the production method of the present invention can be suitably used as a substrate for a display element, a sealing material of an OLED element, an overall protective sheet, or the like.

### Reference Signs List

**10** thin glass
**20, 20'** optical film
**30** application layer
**31** adhesive layer

## Claims

1. A production method for an optical laminate, the production method comprising:
a thin glass production step of producing a thin glass having a thickness of 100 um or less; and
a lamination step of laminating an optical film on one surface, or each of both surfaces, of the thin glass,
the thin glass production step and the lamination step being performed in an integrated line,
wherein thin glass continuously formed in the thin glass production step is subjected to the lamination step as it is without being taken up,
the lamination step comprising applying an adhesive onto the optical film to form an application layer, and bonding the thin glass and the optical film through intermediation of the application layer while thin glass is inserted into a pair of rolls from below, followed by curing the adhesive to form an adhesive layer between the optical film and the thin glass.

2. The production method for an optical laminate according to claim 1, wherein the optical film has a modulus of elasticity at 23°C of from 1.5 GPa to 10 GPa.

3. The production method for an optical laminate according to claim 1 or 2, wherein the adhesive layer has a thickness of from 0.001 um to 20 um.

4. The production method for an optical laminate according to any one of claims 1 to 3, wherein the application layer formed through the application of the adhesive has a curing shrinkage rate of from 0.1% to 30%.

## Patentansprüche

1. Herstellungsverfahren für ein optisches Laminat, wobei das Herstellungsverfahren umfasst:
einen Dünnglas-Herstellungsschritt zur Herstellung eines Dünnglases mit einer Dicke von 100 µm oder weniger; und
einen Laminierungsschritt zur Laminierung eines optischen Films auf eine Oberfläche, oder jede der beiden Oberflächen, des Dünnglases,
wobei der Dünnglas-Herstellungsschritt und der Laminierungsschritt in einer integrierten Linie durchgeführt werden,
wobei Dünnglas, das in dem Dünnglass-Herstellungsschritt kontinuerlich gebildet wird, wird wie es ist dem Laminierungsschritt unterworfen, ohne aufgenommen zu werden,
der Laminierungsschritt umfasst die Anwendung eines Klebstoffs auf den optischem Film, um eine Anwendungsschicht zu bilden, und das Verbinden des Dünnglases und des optischen Films durch Vermittlung der Anwendungsschicht während Dünnglas von unten in ein Walzenpaar eingeführt wird, gefolgt von Härtung des Klebstoffs zur Bildung einer Klebstoffschicht zwischen dem optischen Film und dem Dünnglas.

2. Herstellungsverfahren für ein optisches Laminat gemäß Anspruch 1, wobei der optische Film ein Elastizitätsmodul bei 23 °C von 1,5 GPa bis 10 GPa aufweist.

3. Herstellungsverfahren für ein optisches Laminat gemäß Anspruch 1 oder 2, wobei die Klebstoffschicht eine Dicke von 0,001 µm bis 20 µm aufweist.

4. Herstellungsverfahren für ein optisches Laminat gemäß mindestens einem der Ansprüche 1 bis 3, wobei die durch die Anwendung des Klebstoffs gebildete Anwendungsschicht eine Härtungs-Schrumpfungsrate von 0,1% bis 30% aufweist.

## Revendications

1. Procédé de production pour un stratifié optique, le procédé de production comprenant :
une étape de production de verre mince consistant à produire un verre mince ayant une épaisseur de 100 µm ou moins ; et
une étape de stratification consistant à stratifier un film optique sur une surface, ou sur chacune des deux surfaces, du verre mince,
l'étape de production de verre mince et l'étape de stratification étant mises en oeuvre dans une ligne intégrée, le verre mince formé en continu lors de l'étape de production de verre mince étant soumis à l'étape de stratification tel quel sans être repris,
l'étape de stratification comprend l'application d'un adhésif sur le film optique pour former une couche d'application, et la liaison du verre mince et du film optique par intermédiation de la couche d'application tandis que le verre mince est inséré dans une paire de rouleaux par le bas, suivies du durcissement de l'adhésif pour former une couche adhésive entre le film optique et le verre mince.

2. Procédé de production pour un stratifié optique selon la revendication 1, dans lequel le film optique présente un module d'élasticité à 23 °C compris entre 1,5 GPa et 10 GPa.

3. Procédé de production pour un stratifié optique selon la revendication 1 ou la revendication 2, dans lequel la couche adhésive présente une épaisseur de 0,001 µm à 20 µm.

4. Procédé de production pour un stratifié optique selon l'une quelconque des revendications 1 à 3, dans lequel la couche d'application formée par l'application de l'adhésif présente un taux de retrait au durcissement de 0,1 % à 30 %.
